(19) Europäisches Patentamt
European Patent Office
Office européen des brevets

(11) **EP 3 045 570 B1**

(12) **EUROPEAN PATENT SPECIFICATION**

(45) Date of publication and mention of the grant of the patent:
**22.05.2019 Bulletin 2019/21**

(51) Int Cl.:
**C30B 25/16** *(2006.01)*     **C30B 25/18** *(2006.01)*
**C30B 29/04** *(2006.01)*     **C30B 25/20** *(2006.01)*
**C30B 25/10** *(2006.01)*

(21) Application number: **15187789.1**

(22) Date of filing: **30.09.2015**

(54) **ELECTRONIC DEVICE GRADE SINGLE CRYSTAL DIAMONDS AND METHOD OF PRODUCING THE SAME**

EINKRISTALLINE DIAMANTEN FÜR ELEKTRONISCHE VORRICHTUNGEN UND VERFAHREN ZUR HERSTELLUNG DAVON

DIAMANTS MONOCRISTALLINS DE QUALITÉ ÉLECTRONIQUE ET PROCÉDÉ DE PRODUCTION DE CEUX-CI

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **14.01.2015 SG 10201500278Y**
**10.07.2015 SG 10201505413V**
**24.02.2015 EP 15156409**

(43) Date of publication of application:
**20.07.2016 Bulletin 2016/29**

(73) Proprietor: **IIA Technologies Pte. Ltd.**
**Singapore 049513 (SG)**

(72) Inventors:
• **MISRA, Devi Shanker**
**049513 OCBC Centre (SG)**
• **TARUN, Alvarado**
**049513 OCBC Centre (SG)**

(74) Representative: **Mewburn Ellis LLP**
**City Tower**
**40 Basinghall Street**
**London EC2V 5DE (GB)**

(56) References cited:
**EP-A1- 2 540 877        WO-A1-01/96633**
**WO-A1-2010/010352    WO-A2-2007/081492**

• **GALBIATI A ET AL: "Performance of monocrystalline diamond radiation detectors fabricated using TiW, Cr/Au and a novel ohmic DLC/Pt/Au electrical contact", NUCLEAR SCIENCE SYMPOSIUM CONFERENCE RECORD, 2008. NSS '08. IEEE (19-25 OCT. 2008), IEEE, PISCATAWAY, NJ, USA, 19 October 2008 (2008-10-19), pages 190-196, XP031419420, ISBN: 978-1-4244-2714-7**
• **Tokuyuki Teraji: "Chemical Vapor Deposition of Homoepitaxial Diamond Films" In: "Physics and Applications of CVD Diamond", 1 August 2008 (2008-08-01), WILEY-VCH Verlag GmbH & Co. KGaA, Weinheim, XP055525507, ISBN: 978-3-527-40801-6 pages 29-71,**

## Description

**Field of the Invention**

The invention relates to electronic device grade single crystal diamonds and a method of producing electronic device grade diamonds grown by microwave plasma chemical vapour deposition (MPCVD) process.

**Background**

The demand for electronics device grade single crystal diamonds has been increasing steadily through the years due to its wide-range of scientific and industrial applications, beside gems. The remarkable intrinsic properties of electronic grade single crystal diamonds is one of the reasons why it is a preferred material for industrial and scientific applications, as well as gems.

Diamond deposition by CVD process on various solid substrates have been extensively described in various patent documents and also extensively investigated by researchers and published in scientific journals and other technical literatures. The process of diamond growth by CVD process involves the deposition of carbon atoms that originate from the dissociation of a carbon-containing gas precursor (i.e. $C_xH_y$ (x= 1 to 4)) on a solid substrate under the reaction of a mixture of several gases ($H_2$, Ar, $O_2$, $N_2$, $CO_x$, $CF_x$ etc.). Polycrystalline or single crystal CVD diamonds can be produced and their crystalline quality strongly depends not only on the process chemistry of the gases used, but also on the nature and condition of the solid substrate as well.

Several patent documents and scientific literatures disclose various methods of producing large poly-crystalline diamond films for radiation wave detection. The disadvantages of these large poly-crystalline diamond films is that the firms are not only limited in thickness but also limited in charge collection distance due to the presence of grain boundaries that drastically affect their electronic properties.

European patent publication No. EP1983080A2 discloses the method of producing diamonds suitable for electronic applications by CVD process. However, the electronics properties of these diamonds are believed to be affected by the presence of minute impurities (>1ppm) and lattice defects which will reduces their charge collection efficiency/distance. Production of full collection distance at lower bias field (<0.2V/$\mu$m) detectors based on single crystal diamond with extremely high reproducibility through sufficient control of the growth process and tight selection of solid substrate by CVD process has not been disclosed.

US Patent No. 7,887,628 discloses a layer of single crystal CVD diamond having a thickness of greater than 2mm, wherein the layer has a level of any single impurity of not greater than 1 ppm and a total impurity content of not greater than 5 ppm whereby the impurity excludes hydrogen in isotopic forms and in electron paramagnetic resonance (EPR), a single substitutional nitrogen centre [N-C]° at a concentration <100 ppb.

US Patent Application Publication 2013/0202518 discloses a single crystal CVD diamond having a level of any single impurity of not greater than 5 ppm and a total impurity content of not greater than 10 ppm wherein impurity excludes hydrogen in isotopic forms, and in electron paramagnetic resonance (EPR), a single subsitutional nitrogen centre [N-C]° < 40 ppb.

WO 2010/010352 discloses single crystal diamond having a high chemical purity including a low nitrogen content and a low C13 content, methods for producing the same and a solid state system comprising such single crystal diamond.

Galbiati et al. "Performance of monocrystalline diamond radiation detectors fabricated using TiW, Cr/Au and a novel ohmic DLC/Pt/Au electrical contact", NUCLEAR SCIENCE SYMPOSIUM CONFERENCE RECORD, 2008. NSS '08. IEEE (19-25 Oct 2008), pages 190-196, ISBN: 978-1-4244-2714-7 discloses a single crystal diamond radiation detector having top and bottom electrodes including metallic layers and diamond-like carbon layers.

It is an object of the present invention to provide a method of utilising microwave plasma chemical vapour deposition (MPCVD) process to produce electronic device grade single crystal diamonds having a size up to 10x10x2 mm$^3$ and also with a charge collection efficiency (CCE) of 100% when the bias field is at least 0.2 V/$\mu$m.

The reason of growing thick electronic device grade single crystal diamond is to prevent the formation of crystal defects such as thread dislocations, crystal plane twining, "petal-shape" defects and step-growth related dislocations. Generally, these crystal defects grow and propagate during growth and eventually results in highly stressed MPCVD diamonds. These stresses are known to degrade the charge carrier mobilities and lifetimes of diamond based detectors. The method described herein includes the step of pre-growth conditioning on the diamond substrate so as to suppress the crystal defects from growing and preparing the substrates that are substantially free of crystal defects and impurities.

Other objects and advantages of the present invention will become apparent from the following description, taken in connection with the accompanying drawings, wherein, by way of illustration and example, an embodiment of the present invention is disclosed.

**Summary of invention**

In accordance to a first aspect of the present invention, there is provided a method utilising microwave plasma chemical vapour deposition (MPCVD) process of producing electronic device grade single crystal diamond as set out in claim 1.

In accordance to a second aspect of the present invention, there is provided an electronic device grade single crystal diamond as set out in claim 8. This is an electronic

device grade single crystal diamond comprising: a charge of collection efficiency (CCE) of 100% when the bias field is at least 0.2V/$\mu$m, a low level of nitrogen defined by an absence of a signal for single substitutional nitrogen centres [N-C]° , indicating a concentration of said single substitutional nitrogen centres of <100ppb using FTIR and <100ppb using UV-VIS absorption spectroscopy at 270nm, and typically <30ppb using electron paramagnetic resonance (EPR), an absence of C-H stretch absorption and hydrogen related vibrations in the infrared (IR) spectral range of 2500 cm$^{-1}$ to 3400 cm$^{-1}$ when infrared transmittance is greater than 70% in a FTIR spectrum, and a concentration of silicon related vacancies of <50 ppb defined by an absence of traces of silicon related vacancy peaks (SiV) at 738nm, nitrogen related vacancy peaks (NV-) at 637nm using photoluminescence spectroscopy.

**Brief description of drawings**

This then generally describes the invention but to assist with understanding reference will now be made to the accompanying drawings which show preferred embodiments of the invention.

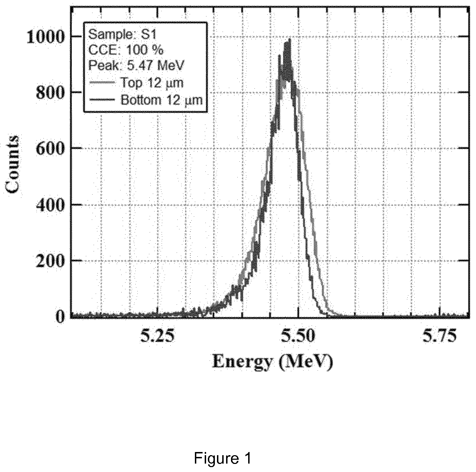

Figure 1 shows a plot of the charge collection efficiency (CCE) (CCE = 100%) measured at the top (red) and bottom (blue) layer of the CVD diamond biased at 0.8V/$\mu$m bias field according to a preferred embodiment of the invention. Energy spectrum was obtained when electronic device grade single crystal diamond detector is exposed to a radiation source in the form of Americium ($^{241}$Am) alpha source.

Figure 2 shows a plot of the CCE as a function of electric field (bias voltage/sample thickness) according to a preferred embodiment of the invention. Full charge collection efficiency of 100% is obtained at bias field of at least 0.2V/$\mu$m.

Figure 3 shows a plot of the drift velocity against electric field at room temperature (295K) according to a preferred embodiment of the invention. The fit result shows low-field mobility and saturation velocity for both holes and electrons.

Figure 4 shows a plot showing collected charge (C) against the inverse of drift velocity at room temperature (295K) according to a preferred embodiment of the invention. The fit result shows the carrier lifetimes for both holes and electrons.

Figure 5 shows charge signal distribution measured from electronic device grade single diamond detector when it is is exposed to a radiation source in the form of Strontium ($^{90}$Sr) radiation source according

to a preferred embodiment of the invention. The landau fit result shows that FWHM/MP is approximately 0.3.

Figure 6 shows the photoluminescence spectrum obtained from 514.5 nm laser excitation measured at room temperature (295K) according to a preferred embodiment of the invention. There is no visible peak from nitrogen and silicon related vacancies.

Figure 7 shows the map of the rocking curve width throughout the entire sample at different crystallographic planes according to a preferred embodiment of the invention. The histogram shows a narrow distribution of the rocking width and at least 90% volume of electronic device grade single crystal diamond lies below 40 micro radians ($\mu$Rad).

Figure 8 shows the cross-polarized image taken from the electronic-device grade single crystal diamond produced by the method at 40x magnification according to a preferred embodiment of the invention. There are no visible traces of large dislocations. However, there are petal-shape defects and inclusions occuring as brighter contrast in the cross-polarized image.

Figure 9 shows a plot of the typical FTIR spectrum of the electronic-device grade single crystal diamond according to a preferred embodiment of the invention.

Figure 10 shows a plot of the UV-VIS spectrum measured from the electronic-device grade single crystal diamond according to a preferred embodiment of the invention. As shown, there is no traces of detectable nitrogen related peaks at 270nm in the UV region and silicon related peaks at 738nm.

Figure 11 shows the photoluminescence spectra of diamonds having similar level of intensities for energy resolution dependence study according to a preferred embodiment of the invention.. The insert shows energy spectrum when electronic device grade single crystal diamond detector is exposed to a radiation source in the form of Americium ($^{241}$Am) radiation source taken at 0.8V/$\mu$m bias field. The spectrum is fitted using the landau equation.

Figure 12 shows the map of the rocking curve width of various samples of diamond based detectors and the corresponding histograms of RC width for quantification of average RC peak and RC width distribution according to a preferred embodiment of the invention.

**Detailed Description**

The Figures are diagrammatic and not drawn to scale. In the Figures, elements which correspond to elements already described have the same reference numerals.

According to an aspect of the present invention, there is provided a method utilising microwave plasma chemical vapour deposition (MPCVD) process to produce electronic device grade single crystal diamonds.

The first step comprises of selecting a diamond seed or substrate having a pre-determined orientation. In a preferred embodiment of the present invention, the orientation of the diamond seeds or substrate is {001}. In a preferred embodiment of the present invention, the selection of the substrate having a pre-determined orientation is performed by looking at the high magnification optical images of 100X to check for surface defects, polishing induced defects, etch pits and inclusions. In another embodiment of the present invention, the high magnification optical images of 40X may be used. In a preferred embodiment of the present invention, a cross-polarized imaging may be performed on the High Pressure, High Temperature (HPTH) grown, natural, or MPCVD grown diamond to check for the presence of any lattice imperfection as a result due to strain. Crystal-axis check of the substrate is also performed to ensure that off-axis angle relative to the {100} orientation axis does not exceed 3 degrees. Etching the top surface of the substrate to reveal and/or remove the surface damage is performed to reduce the overall defect density.

The second step comprises of cleaning and etching of non-diamond phases and other induced surface damages from the diamond seed or substrate. Non-diamond phases are removed from the substrate by cleaning it in a boiling acid bath having temperature greater than 300°C and subsequently underwent different plasma etching for 30 to 180 minutes. Plasma etching of acid cleaned substrates by microwave plasma chemical vapour deposition (MPCVD) involves etching temperature from about 700°C to about 1200°C in a MPCVD chamber having an atmosphere with a pressure of about 100 to 300 torr, wherein the atmosphere therein comprises of about 0.1% to about 10% oxygen per unit of hydrogen. The plasma etching method for substrate preparations take place in a MPCVD chamber considerably free of nitrogen. The MPCVD chamber also comprises of gas precursors which are well purified such that the total impurities is less than 500 ppb in a preferred embodiment of the present invention. In other embodiments, the impurities may be less than 1ppm.

The third step comprises of growing a layer of extremely low crystal defect density diamond surface on the cleaned / etched diamond seed or substrate. The pre-growth process for production of electronic device grade single crystal diamond by microwave plasma chemical vapour deposition (MPCVD) on the growth surface of the diamond seeds takes place at a temperature from about 700°C to about 1200°C in a MPCVD chamber, wherein the atmosphere therein comprises of a mixture of about 1% to about 15% $CH_4$ per unit of $H_2$ only or with some additional mixture of about 1% to about 50% $O_2$ per unit of $CH_4$.

The fourth step comprises of growing electronic device grade single crystal diamond on top of the layer of low crystal defect density diamond surface. The method of growing electronic device grade single crystal diamond includes controlling temperature of a growth surface of about 700°C to about 1200°C in a MPCVD chamber, wherein the pressure therein comprises of about 100 to about 300 torr and the atmosphere therein comprises of a mixture of about 0.1% to about 15% $CH_4$ per unit of $H_2$.

It is submitted that the growth rate of electronic device grade single crystal diamond is 1 $\mu$m/hour to 15 $\mu$m/hour.

In other embodiments of the present invention, the second and third steps may be repeated more than one time so as to achieve a desired and optimum result.

During the whole process of pre-growth and growth of electronic device grade single-crystal diamond, the incorporation of impurities is well controlled by making sure that the MPCVD chamber where the diamond growth takes place is considerably free of nitrogen. In addition, gas precursors are also well purified such that the total impurities is less than 500ppb in a preferred embodiment of the present invention. In other embodiments, the impurities may be less than 1ppm.

It is submitted that the method produces an electronic device grade single-crystal diamond with the characteristics as described hereinafter.

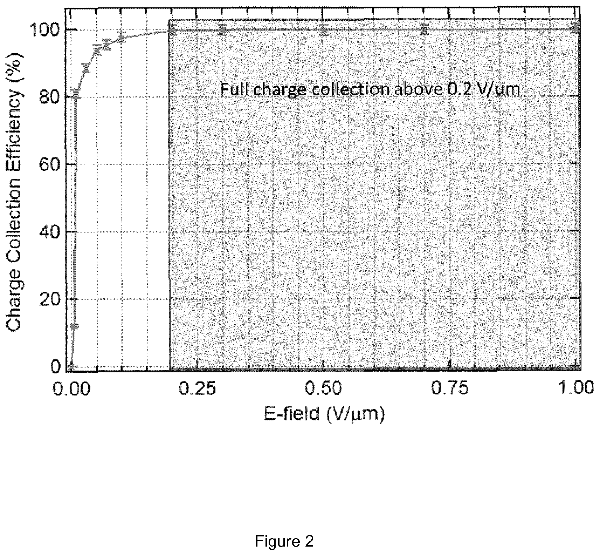

In accordance with an aspect of the present invention, the electronic device grade single-crystal diamond comprises of a charge collection efficiency (CCE) of 100% when the bias field of at least 0.2V/$\mu$m as shown in Figure 2. Charge collection efficiency (CCE) is the ratio of the total charge detected to the total charge generated by radiation source in the form of Alpha Americium source. The measured charge collection distance of electronic device grade single crystal diamond produced by MPCVD process is limited by the sample thickness. Collection distance of 1000 $\mu$m can be obtained at 200V electrical bias when using a radiation source in the form of beta radiation source (Strontium $^{90}$Sr).

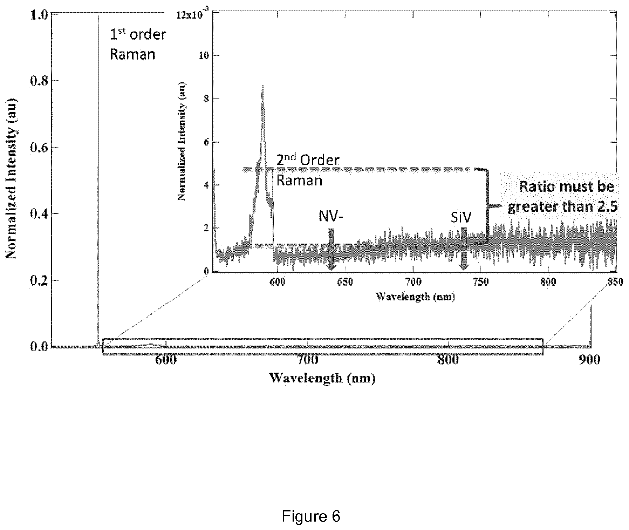

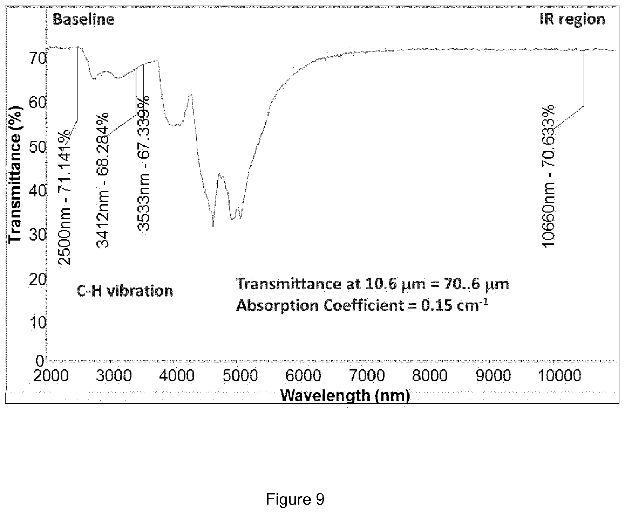

In accordance with an aspect of the present invention, the electronic device grade single crystal diamond exhibits a low level of nitrogen. The low level of nitrogen is determined in photoluminescence spectrum in Figure 6 and in the typical FTIR spectrum in Figure 9. In a preferred embodiment of the present invention, there is an absence of a signal for single substitutional nitrogen centres [N-C]° which indicates a concentration of said single substitutional nitrogen centres of <100ppb using FTIR and <100ppb using UV-VIS absorption spectroscopy at 270nm, and typically <30ppb using electron paramagnetic resonance (EPR).

As shown in a typical FTIR spectrum in Figure 9, when infrared transmittance is greater than 70% which approaches theoretical demand for diamond, there is an absence of C-H stretch absorption and hydrogen related vibrations in the infrared (IR) spectral range of 2500 cm$^{-1}$ to 3400 cm$^{-1}$. In a preferred embodiment of the present invention, the substitution nitrogen has values of [NVH]$^0$ = 3123 cm$^{-1}$, Ns$^+$ = 1332 cm$^{-1}$ and Ns$^0$ = 1344 cm$^{-1}$ and the hydrogen related vibrations has a value of 2500 cm$^{-1}$ to 3400 cm$^{-1}$.

In other embodiments, the level of nitrogen may be quantified by other suitable experimental techniques.

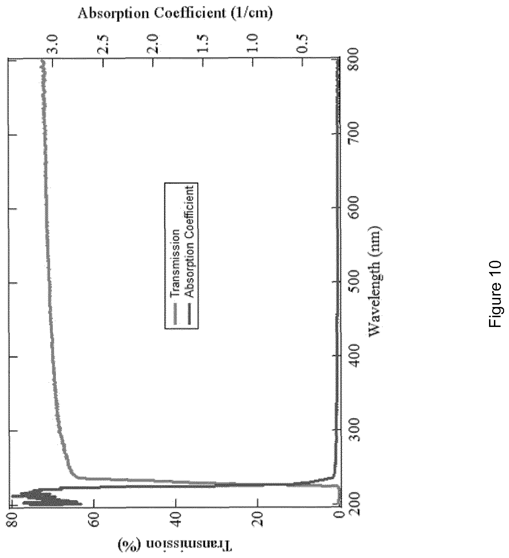

In accordance with an aspect of the present invention, the electronic device grade single crystal diamond also exhibits concentration of silicon related vacancies of <50 ppb. The concentration of silicon related vacancies of <50 ppb using photoluminescence spectroscopy as shown in a plot of the UV-VIS spectrum measured from the diamond is shown in Figure 10. In a preferred embodiment of the present invention, there is an absence of traces of silicon related vacancy peaks (SiV) at 738nm, nitrogen related vacancy peaks (NV-) at 637nm.

In a preferred embodiment of the present invention, the resistance of the electronic device grade single crystal diamond produced by MPCVD process at room temperature is greater than $1 \times 10^{15}$ Ω as obtained from I-V measurement. The C-V measurements show that the capacitance of less than 2pF can be easily obtained. The capacitance approaches close to the theoretical limit.

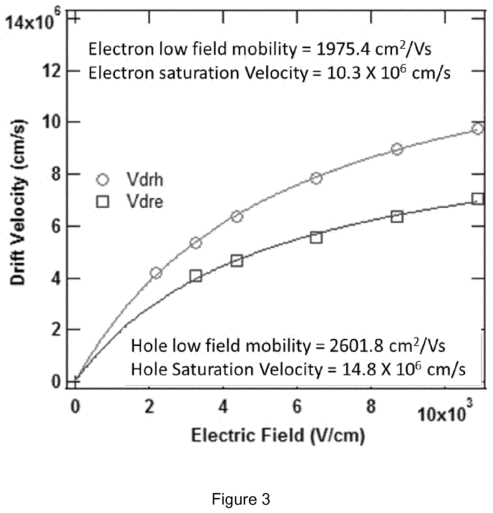

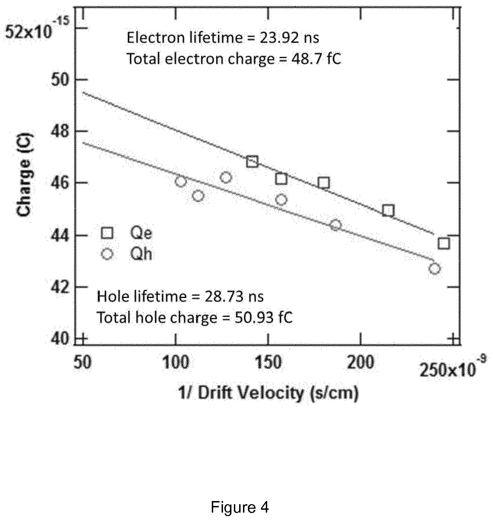

In accordance with an aspect of the present invention, the electronic device grade single crystal diamond has low field electron mobility $\mu_{0,e}$ greater than 1800 cm$^2$/Vs and low field hole mobility $\mu_{0,h}$ greater than 2600 cm$^2$/Vs for both electrons and holes at room temperature respectively. The saturation velocity ($v_{sat}$) for electrons and holes are $v_{sat,e} > 1.0 \times 10^7$ cm/s and $v_{sat,h} > 1.4 \times 10^7$ cm/s respectively. The carrier mobility and drift velocity of the diamond are obtained by transient current technique (TCT) as shown in Figure 3. The carrier lifetime ($\tau$) for electrons, $\tau_e > 20.0$ ns whereas the carrier lifetime for holes, $\tau_h > 25.0$ ns can be obtained as shown in the plot in Figure 4.

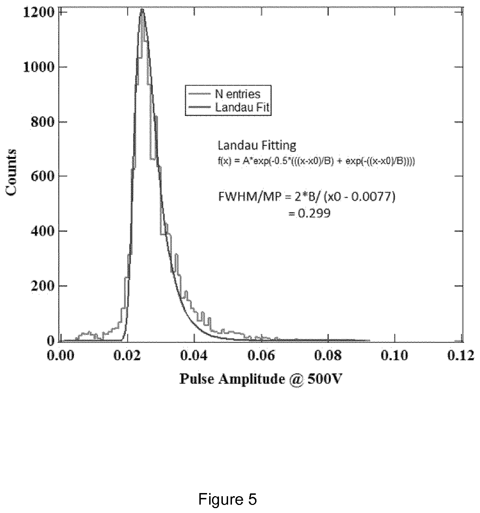

In a preferred embodiment of the present invention, the charge signal distribution of the electronic device grade single crystal diamond has the shape of a Landau distribution curve where the most probable peak of the charge signal distribution depends on the density of defects and impurities in the electronic device grade single crystal diamond. The ratio of full-width-at-half-maximum (FWHM) to the most probable peak (MP) from charge (positive Landau) signal distribution (FHWM/MP) is smaller than 0.3. The charge signal distribution measured from the electronic device grade single crystal diamond detector is obtained when it is exposed to a radiation source in the form of Strontium ($^{90}$Sr) radiation source is shown in Figure 5.

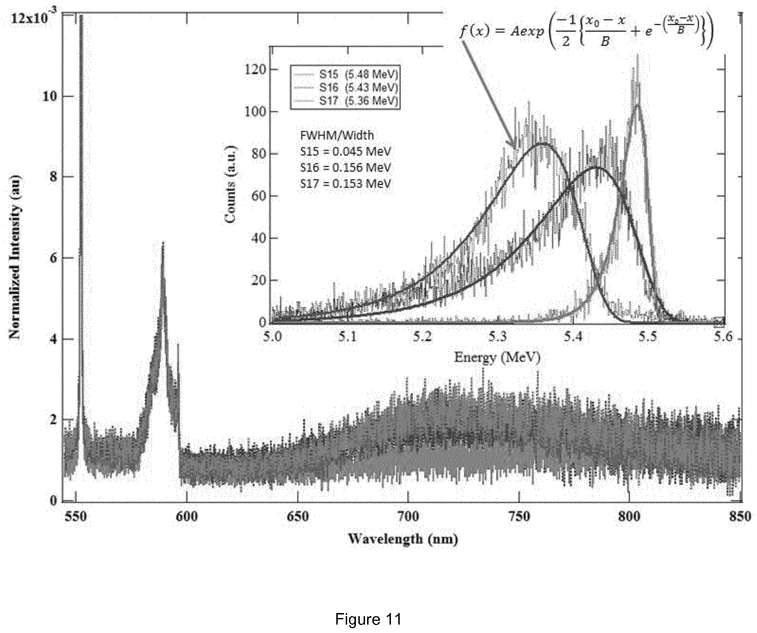

Figure 11 shows the fluorescence spectra of three (3) samples of diamond based detectors having nearly the same level of fluorescence intensity (impurities) in a preferred embodiment of the present invention. The inset shows the $^{241}$Am energy spectra obtained from these 3 samples at 0.8V/μm bias field. The data was fitted with negative landau distribution with amplitude $A$,

$$f(x) = A exp\left(\frac{-1}{2}\left\{\frac{-x+x_0}{B} + e^{-\left(\frac{-x+x_0}{B}\right)}\right\}\right), \text{ in or-}$$

der to obtain the most probably peak (xo) for CCE calculation. The width of the energy spectrum provides the energy resolution response of the diamond based detector which can be obtained from parameter $B$. The fitting results are depicted at the inset labelled as FWHM/Width. As shown, although the level of fluorescence intensities (impurities) of the 3 samples are the same, but the level of CCE of the three diamond based detectors are different.

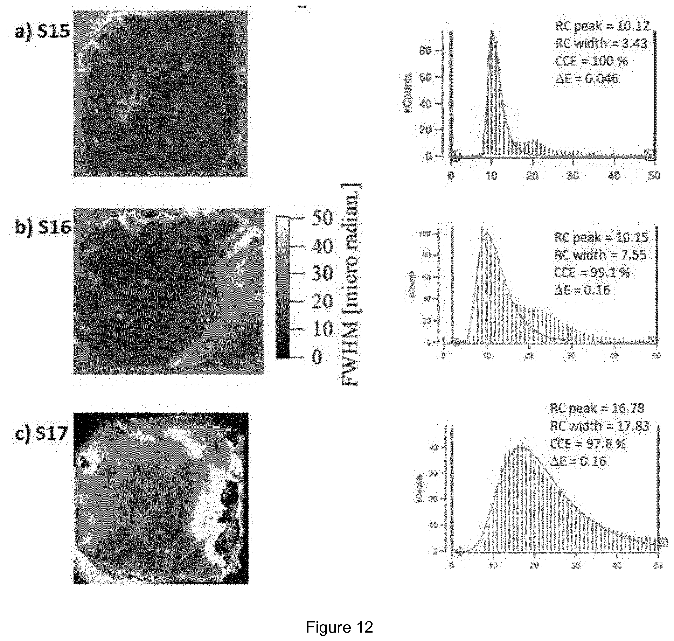

Figure 12 shows the map of x-ray rocking curve (RC) width of the three samples accompanied by their respective histograms. Sample 17 which has broader distribution of RC width and higher average RC width shows a drop in the CCE even though it has the lowest fluorescence intensity (impurities) among the three samples. The FHWM/MP widens as the RC width distribution is broadened. Energy resolution of less than 0.7% can be obtained for RC width distribution of less than 4.0 μRadian.

The ratio of full-width-at-half-maximum (FWHM) to the most probable peak (MP) from charge (negative Landau) signal distribution is FHWM/MP < 3.0% when the electronic device grade single crystal diamond detector is exposed to a radiation source in the form of Americium ($^{241}$Am) radiation source is shown in Figure 12.

This result implies that the energy resolution of the diamond based detector is mostly affected by the value of RC width distribution. The smaller the RC width distribution, the higher the CCE, as shown In Figure 12.

Thus, the electronic device grade single diamond has a low lattice defect when the energy resolution of the diamond based detectors is low, which correspond to a small rocking curve (RC) width distribution which result in a high CCE. As shown in Figure 12, sample S15 has a CCE of 100% when the RC width distribution is 3.43, which is lower than that of those of other samples.

Thus, the RC width distribution is a method used to further assess the electronic properties (i.e. CCE) of the electronic device grade single crystal diamond. However, such a method is restricted to only for diamond with already very low impurities. Hence, RC width as well as the ultra-low fluorescence play a very important role in making a good detector base on diamond.

In a preferred embodiment of the present invention, the ratio of the 2$^{nd}$ order Raman peak (~596nm) to the photoluminescence line of negatively charged nitrogen vacancy (NV$^-$= 637nm) and silicon vacancy (SiV = 738nm) is greater than 2.5 as shown in the photoluminescence spectrum in Figure 6. The photoluminescence spectrum is obtained from 514.5nm Argon excitation source at room (295K) temperature. Low temperature (77K) photoluminescence at 488nm laser excitations does not show any visible defects or fluorescence intensity (impurities) in the range of 490-900nm. All peaks are normalised with respect to Raman first order line at 552 nm. Thus, low fluorescence intensity (impurities) is determined when low temperature (77K) photoluminescence at 488nm laser excitations does not show any visible defects in the range of 490nm to 900nm, whereby the photoluminescence spectrum is obtained from 514.5nm Argon excitation source at room (295K) temperature.

In accordance with an aspect of the present invention, the electronic device grade single diamond having a thickness up to $2500\mu$m is produced. In a preferred embodiment of the present invention, a diamond seed layer having a thickness of less than 2500 $\mu$m may be attached to a substrate.

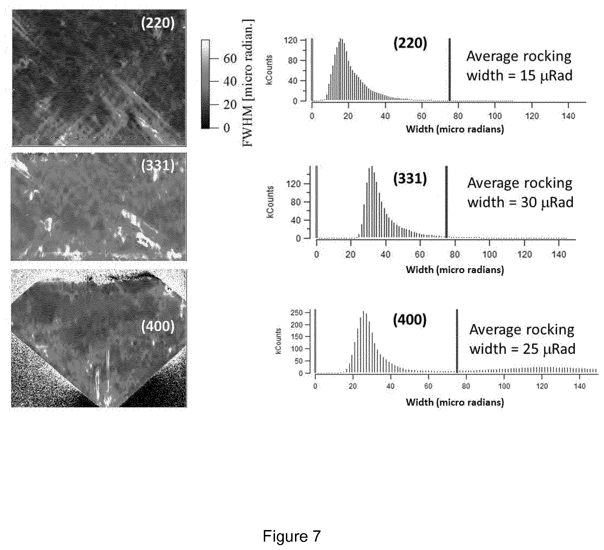

Beside impurities which affects the electronic device grade single crystal diamond's electronic properties, it is found that lattice defects and dislocations reduce the carrier lifetimes by trapping radiation generated charges at the defect sites. The electronic device grade single crystal diamond of the present invention has a very narrow average rocking curve width that does not exceed 40 micro radians in at least 90% volume of the electronic device grade single diamond as shown in the map of the rocking curve in Figure 7 in the preferred embodiment of the present invention. The corresponding distribution of the rocking curve width is displayed as histogram. Generally, a smaller rocking curve width (darker regions) indicates good lattice structure and a larger rocking curve width (brighter region) indicates lattice imperfection. This is true for different crystallographic planes (220), (331), (400).

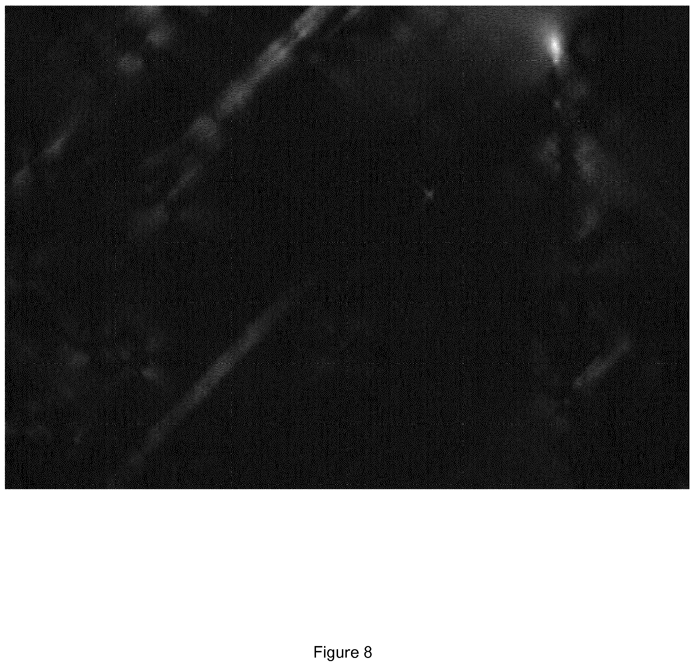

Cross-polarized image showing nearly an absence of brighter areas indicates that the electronic device grade single crystal diamond has substantially low stress and low lattice imperfection as shown in Figure 8. As shown, no inclusions and petal like structures are observed. Other characteristics include low fluorescent intensity (impurities).

It is submitted that the inclusion in the electronic device grade single crystal diamond affects the electronic characteristics in a detrimental manner. It is preferably that the aerial density of inclusions must be $<10^3/m^2$ so as not to affect the electronic characteristics of the electronic device grade single crystal diamond.

It is apparent to a person skilled in the art that many modifications, alternatives and variations may be made to the preferred embodiment of the present invention as described above without departing from the scope of the present invention. Accordingly, it is intended to embrace all such modifications, alternatives and variations that fall within the scope of the included claims.

**Claims**

1. A method utilising microwave plasma chemical vapour deposition (MPCVD) process of producing electronic device grade single crystal diamond comprising:

(a) selecting a diamond seed or substrate having a pre-determined orientation;
(b) cleaning and etching of non-diamond phases and other induced surface damages from the diamond seed or substrate, whereby this step is performed one or more times, and wherein this step comprises removing non-diamond phases from the substrate by cleaning it in a boiling acid bath having temperature greater than 300°C and subsequently plasma etching for 30 to 180 minutes, at an etching temperature from 700°C to 1200°C in a MPCVD chamber having an atmosphere with a pressure of 13.3 to 40 kPa (100 to 300 torr), and wherein the atmosphere therein comprises of 0.1% to 10% oxygen per unit of hydrogen;
(c) growing a layer of extremely low crystal defect density diamond surface on the cleaned / etched diamond seed or substrate, whereby this step is performed one or more times as a pre-growth process for production of electronics device grade single crystal diamond by microwave plasma chemical vapour deposition (MPCVD) on the growth surface of the diamond seed, wherein the pre-growth process takes place at a temperature from 700°C to 1200°C in a MPCVD chamber, wherein the atmosphere comprises 1% to 15% $CH_4$ per unit of $H_2$ only, optionally with some additional mixture from 1% to 50% $O_2$ per unit of $CH_4$; and
(d) growing electronics device grade single crystal diamond on top of the layer of the low crystal defect density diamond surface, wherein the growth rate of the electronics device grade single crystal diamond is 1 $\mu$m/hour to 15 $\mu$m/hour.

2. The method according to claim 1, wherein the diamond seed or substrate have an orientation of {100}.

3. The method accordingly to claim 1 or 2, wherein step (a) comprises of looking at the high magnification optical images of 100X to check for surface defects, polishing induced defects, etch pits and inclusions.

4. The method according to any one of the preceding claims, wherein step (a) further comprises of subsequently performing cross-polarised imaging on the diamond seed to check for the presence of any lattice imperfection as a result of strain, and performing crystal-axis check of the substrate to ensure that off-axis angle relative to the {100} orientation axis does not exceed 3 degrees, and if necessary, etching the top surface to reveal and / or remove the surface damage to reduce the overall defect density.

5. The method according to claim 1, wherein the plasma etching method for diamond preparations take place in a MPCVD chamber considerably free of nitrogen, and the MPCVD chamber comprises of gas precursors which are well purified such that the total impurities is less than 500ppb.

6. The method according to any one of the preceding claims, wherein step (d) further comprises of controlling temperature of a growth surface of 700°C to 1200°C in a MPCVD chamber, wherein the pressure comprises 13.3 to 40 kPa (100 to 300 torr) and the atmosphere comprises of a mixture of 0.1% to 15% $CH_4$ per unit of $H_2$.

7. The method according to any one of the preceding claims, wherein the incorporation of impurities are well controlled by making sure the MPCVD chamber where the diamond growth take place are considerably free of nitrogen, and also by making sure gas precursors are well purified such that the total impurities is less than 500ppb.

8. An electronic device grade single crystal diamond comprising:

> a charge of collection efficiency (CCE) of 100% when the bias field is at least 0.2V/$\mu$m,
> a low level of nitrogen defined by an absence of a signal for single substitutional nitrogen centres [N-C]° , indicating a concentration of said single substitutional nitrogen centres of <100ppb using FTIR and <100ppb using UV-VIS absorption spectroscopy at 270nm, and typically <30ppb using electron paramagnetic resonance (EPR),
> an absence of C-H stretch absorption and hydrogen related vibrations in the infrared (IR) spectral range of 2500 cm$^{-1}$ to 3400 cm$^{-1}$ when infrared transmittance is greater than 70% in a FTIR spectrum, and
> a concentration of silicon related vacancies of <50 ppb defined by an absence of traces of silicon related vacancy peaks (SiV) at 738nm, nitrogen related vacancy peaks (NV-) at 637nm using photoluminescence spectroscopy.

9. The electronic device grade single crystal diamond according to claim 8, wherein the substitution nitrogen has values of [NVH]$^0$ = 3123 cm$^{-1}$, Ns$^+$ = 1332 cm$^{-1}$ and Ns$^0$ = 1344 cm$^{-1}$ and the hydrogen related vibrations has a value of 2500 cm$^{-1}$ to 3400 cm$^{-1}$.

10. The electronic device grade single crystal diamond according to claim 8 or 9, wherein the diamond comprises of having a resistance greater than 1x10$^{15}$ $\Omega$ as obtained from I-V measurement, and the diamond has low field electron mobility $\mu_{0,e}$ greater than 1800 cm$^2$/Vs and low field hole mobility $\mu_{0,h}$ greater than 2600 cm$^2$/Vs for electrons and holes at room temperature.

11. The electronic device grade single crystal diamond according to any one of claims 8 to 10, wherein the saturation velocity ($v_{sat}$) for electrons and holes are $v_{sat,e}$ > 1.0$\times$10$^7$ cm/s and $v_{sar,h}$ > 1.4$\times$10$^7$ cm/s respectively, and the carrier lifetime ($\tau$) for electrons, $\tau_e$ > 20.0 ns whereas for holes, the carrier lifetime $\tau_h$ > 25.0 ns.

12. The electronic device grade single crystal diamond according to any one of claims 8 to 11, further has a charge signal distribution with the shape of a Landau distribution curve where the most probable peak of the charge signal distribution depends on the density of defects and impurities in the electronic device grade single crystal diamond, and the ratio of full-width-at-half-maximum (FWHM) to the most probable peak (MP) from charge (Landau) distribution (FHWM/MP) is smaller than 0.3.

13. The electronic device grade single crystal diamond according to any one of claim 8 to 12, further has a low lattice defect defined by the low energy resolution of the diamond based detectors, which correspond to a small rocking curve (RC) width distribution which result in a high CCE.

14. The electronic device grade single crystal diamond according to claim 13, wherein the rocking curve (RC) width distribution is less than 4.0 $\mu$Radian, which is used to obtain an energy resolution of less than 0.7%, wherein the low percentage of the energy resolution correspond to the low value of the ratio of full-width-at-half-maximum (FWHM) to the most probable peak (MP) from charge (negative Landau) signal distribution, FHWM/MP, in which FHWM/MP < 3.0% when the electronic device grade single crystal diamond detector is exposed to a radiation source in the form of Americium ($^{241}$Am) radiation source.

15. The electronic device grade single crystal diamond according to any one of claims 8 to 14, further comprise of low fluorescence intensity (impurities) defined by low temperature (77K) photoluminescence at 488nm laser excitations which does not show any visible defects in the range of 490nm to 900nm, whereby the photoluminescence spectrum is obtained from 514.5nm Argon excitation source at room (295K) temperature.

16. The electronic device grade single crystal diamond according to any one of claims 8 to 15, wherein the diamond seed layer having a thickness up to 2500 μm is attached to a substrate, and the diamond has very narrow average rocking curve width that does not exceed 40 micro radians in at least 90% volume of the diamond, the rocking curve being measured for at least one of crystallographic planes (220), (331) and (400).

17. The electronic device grade single crystal diamond according to any one of claims 8 to 16, further has an aerial density of inclusion $<10^3/m^2$.

**Patentansprüche**

1. Verfahren, das ein Verfahren der chemischen Gasphasenabscheidung mittels Mikrowellenplasma nutzt, zur Herstellung von Einkristall-Diamanten für elektronische Vorrichtungen, das Folgendes umfasst:

   (a) das Auswählen eines Diamanten-Impfkristalls oder -Substrats mit einer vorbestimmten Orientierung;
   (b) das Reinigen und Ätzen von Nichtdiamant-Phasen und anderen erzeugten Oberflächenschäden vom Diamanten-Impfkristall oder -Substrat, wobei dieser Schritt ein oder mehrere Male durchgeführt wird und wobei dieser Schritt das Entfernen von Nichtdiamant-Phasen vom Substrat durch dessen Reinigung in einem siedenden Säurebad mit einer Temperatur von mehr als 300 °C und das darauffolgende 30 bis 180 Minuten lange Plasmaätzen bei einer Ätztemperatur von 700 °C bis 1200 °C in einer MPCVD-Kammer umfasst, die eine Atmosphäre mit einem Druck von 13,3 bis 40 kPa (100 bis 300 torr) aufweist, und wobei die Atmosphäre 0,1 % bis 10 % Sauerstoff pro Wasserstoffeinheit aufweist;
   (c) das Züchten einer Diamantenoberflächenschicht mit extrem geringer Kristalldefektdichte auf dem gereinigten/geätzten Diamanten-Impfkristall oder -Substrat, wobei dieser Schritt ein oder mehrere Male als Vorzüchtungsverfahren zur Herstellung von Einkristall-Diamanten für elektronische Vorrichtungen durch chemische Gasphasenabscheidung mittels Mikrowellenplasma (MPCVD) auf der Züchtungsoberfläche des Impfkristalls durchgeführt wird, wobei das Vorzüchtungsverfahren bei einer Temperatur von 700 °C bis 1200 °C in einer MPCVD-Kammer stattfindet, in der die Atmosphäre nur 1 % bis 15 % $CH_4$ pro $H_2$-Einheit, gegebenenfalls mit einem zusätzlichen Gemisch von 1 % bis 50 % $O_2$ pro $CH_4$-Einheit, umfasst; und
   (d) das Züchten eines Einkristall-Diamanten für elektronische Vorrichtungen auf der Diamantenoberflächenschicht mit niedriger Kristalldefektdichte, wobei die Züchtungsgeschwindigkeit des Einkristall-Diamanten für elektronische Vorrichtungen 1 μm/h bis 15 μm/h beträgt.

2. Verfahren nach Anspruch 1, wobei der Diamanten-Impfkristall oder das Diamantensubstrat eine Orientierung von {100} aufweist.

3. Verfahren nach Anspruch 1 oder 2, wobei Schritt (a) das Untersuchen der optischen Bilder mit 100-facher Vergrößerung umfasst, um diese auf Oberflächenschäden, Schäden aufgrund von Polieren, Ätzgruben und Einschlüsse zu überprüfen.

4. Verfahren nach einem der vorangegangenen Ansprüche, wobei Schritt (a) außerdem das anschließende Durchführen von kreuzpolarisierter Bildgebung auf dem Diamanten-Impfkristall, um die Gegenwart von Gitterfehlerstellen als Ergebnis von Belastung zu untersuchen, und das Durchführen einer Kristallachsenüberprüfung auf dem Substrat, um sicherzustellen, dass der außeraxiale Winkel in Bezug auf die {100}-Orientierungsachse nicht über 3 Grad hinausgeht, und nach Bedarf das Ätzen der Oberfläche umfasst, um den Oberflächenschaden freizulegen/zu entfernen und somit die Defektdichte insgesamt zu verringern.

5. Verfahren nach Anspruch 1, wobei das Plasmaätzverfahren für Diamantenpräparate in einer MPCVD-Kammer im Wesentlichen ohne Stickstoff stattfindet und die MPCVD-Kammer Gasvorläufer umfasst, die gut gereinigt sind, sodass die Gesamtverunreinigung weniger als 500 ppb beträgt.

6. Verfahren nach einem der vorangegangenen Ansprüche, wobei Schritt (d) außerdem das Kontrollieren der Temperatur einer Züchtungsoberfläche auf 700 °C bis 1200 °C in einer MPCVD-Kammer umfasst, wobei der Druck 13,3 bis 40 kPa (100 bis 300 torr) und die Atmosphäre ein Gemisch aus 0,1 % bis 15 % $CH_4$ pro $H_2$-Einheit umfasst.

7. Verfahren nach einem der vorangegangenen Ansprüche, wobei die Aufnahme von Verunreinigungen durch das Sicherstellen, dass die MPCVD-Kammer, in der die Diamantenzüchtung stattfindet, im Wesentlichen frei von Stickstoff ist, und außerdem durch das Sicherstellen, dass Gasvorläufer gut gereinigt sind, gut gesteuert wird, sodass die Gesamtverunreinigungen weniger als 500 ppb betragen.

8. Einkristall-Diamant für elektronische Vorrichtungen, der Folgendes umfasst:

   eine Abscheideleistung-Ladung (CCE) von 100 %, wenn das Bias-Feld zumindest 0,2 V/μm be-

trägt,

ein niedriges Stickstoffausmaß, das durch die Abwesenheit eines Signals für einzelne substitutionelle Stickstoffzentren [N-C]°, das eine Konzentration der einzelnen substitutionellen Stickstoffzentren von <100 ppb unter Verwendung von FTIR und <100 ppb unter Verwendung von UV-VIS-Absorptionsspektroskopie bei 270 nm und üblicherweise <30 ppb unter Verwendung von Elektronenspinresonanz (EPR) anzeigt, eine Abwesenheit von C-H-Streckschwingungsabsorption und Wasserstoff-bezogenen Schwingungen im Infrarot- (IR-) Spektralbereich von 2500 cm$^{-1}$ bis 3400 cm$^{-1}$ definiert ist, wenn die Infrarotdurchlässigkeit in einem FTIR-Spektrum mehr als 70 % beträgt, und

eine Konzentration von Silicium-bezogenen Lücken von <50 ppb, die durch eine Abwesenheit von Spuren von Silicium-bezogenen Lückenpeaks (SiV) bei 738 nm und Stickstoff-bezogenen Lückenpeaks (NV-) bei 637 nm unter Verwendung von Photolumineszenzspektroskopie definiert ist.

9. Einkristall-Diamant für elektronische Vorrichtungen nach Anspruch 8, wobei der Substitutionsstickstoff Werte von [NVH]$^0$ = 3123 cm$^{-1}$, Ns$^+$ = 1332 cm$^{-1}$ und Ns$^0$ = 1344 cm$^{-1}$ aufweist und die Wasserstoff-bezogenen Schwingungen einen Wert von 2500 cm$^{-1}$ bis 3400 cm$^{-1}$ aufweisen.

10. Einkristall-Diamant für elektronische Vorrichtungen nach Anspruch 8 oder 9, wobei der Diamant einen Widerstand von mehr als 1x10$^{15}$ $\Omega$, wie durch I-V-Messung erhalten, aufweist und der Diamant eine Schwachfeldelektronenmobilität $\mu_{0,e}$ über 1800 cm$^2$/Vs und eine Schwachfeldlöchermobilität $\mu_{0,h}$ über 2600 cm$^2$/Vs für Elektronen und Löcher bei Raumtemperatur aufweist.

11. Einkristall-Diamant für elektronische Vorrichtungen nach einem der Ansprüche 8 bis 10, wobei die Sättigungsgeschwindigkeit ($v_{sat}$) für Elektronen und Löcher $v_{sat,e}$ >1,0 x 10$^7$ cm/s bzw. $v_{sat,h}$ >1,4 x 10$^7$ cm/s beträgt und die Ladungsträgerlebensdauer ($\tau$) für Elektronen $\tau_e$ > 20,0 ns beträgt, wohingegen die Ladungsträgerlebensdauer für Löcher $\tau_h$ > 25,0 ns beträgt.

12. Einkristall-Diamant für elektronische Vorrichtungen nach einem der Ansprüche 8 bis 11, der außerdem eine Ladungssignalverteilung in Form einer Landau-Verteilungskurve aufweist, wobei der wahrscheinlichste Peak der Ladungssignalverteilung von der Dichte der Defekte und Verunreinigungen im Einkristall-Diamant für elektronische Vorrichtungen abhängt und das Verhältnis von Halbwertsbreite (FWHM) zu wahrscheinlichstem Peak (MP) der Ladungs- (Landau-) Verteilung (FHWM/MP) kleiner als 0,3 ist.

13. Einkristall-Diamant für elektronische Vorrichtungen nach einem der Ansprüche 8 bis 12, der außerdem einen geringen Gitterdefekt aufweist, der durch die niedrige Energieauflösung der Diamanten-bezogenen Detektoren definiert ist, der einer kleinen Schwingungskurve- (RC-) Breitenverteilung entspricht, die zu einer hohen CCE führt.

14. Einkristall-Diamant für elektronische Vorrichtungen nach Anspruch 13, wobei die Schwingungskurve- (RC-) Breitenverteilung weniger als 4,0 $\mu$rad beträgt, durch die üblicherweise eine Energieauflösung von weniger als 0,7 % erhalten wird, wobei der niedrige Prozentsatz der Energieauflösung dem niedrigen Wert des Verhältnisses von Halbwertsbreite (FWHM) zu wahrscheinlichstem Peak (MP) der Ladungs-(negative Landau-) Signalverteilung, FHWM/MP, entspricht, wobei FHWM/MP <3,0 % beträgt, wenn der Detektor für Einkristall-Diamanten für elektronische Vorrichtungen einer Strahlungsquelle in Form einer Americium- ($^{241}$Am-) Quelle ausgesetzt ist.

15. Einkristall-Diamant für elektronische Vorrichtungen nach einem der Ansprüche 8 bis 14, der außerdem eine geringe Fluoreszenzintensität (Verunreinigungen) aufweist, die durch eine Niedrigtemperaturphotolumineszenz (77K) bei 488-nm-Laseranregungen definiert ist, die keine sichtbaren Defekte im Bereich von 490 nm bis 900 nm zeigt, wodurch das Photolumineszenzspektrum von 514,5-nm-Argon-Anregungsquelle bei Raumtemperatur (295 K) erhalten wird.

16. Einkristall-Diamant für elektronische Vorrichtungen nach einem der Ansprüche 8 bis 15, wobei die Diamantenimpfschicht, die eine Dicke von bis zu 2500 $\mu$m aufweist, mit einem Substrat verbunden ist und der Diamant eine sehr schmale mittlere Schwingungskurvenbreite aufweist, die 40 Mikrorad in zumindest 90 % des Diamantenvolumens nicht übersteigt, wobei die Schwingungskurve für zumindest eine der kristallographischen Ebenen (220), (331) und (400) gemessen wird.

17. Einkristall-Diamant für elektronische Vorrichtungen nach einem der Ansprüche 8 bis 16, der außerdem eine Einschlussluftdichte von <10$^3$/m$^2$ aufweist.

**Revendications**

1. Procédé utilisant un processus de dépôt chimique en phase vapeur par plasma micro-onde (MPCVD) pour produire un diamant monocristallin de qualité électronique et comprenant :

(a) la sélection d'un germe ou substrat de diamant présentant une orientation prédéterminée,
(b) le nettoyage et/ou le décapage des phases non diamantifères et d'autres dommages superficiels induits du germe ou du substrat de diamant, moyennant quoi cette étape est effectuée une ou plusieurs fois, et dans lequel cette étape comprend l'élimination des phases non diamantifères du substrat par nettoyage de celui-ci dans un bain d'acide bouillant ayant une température supérieure à 300 °C puis par décapage au plasma pendant 30 à 180 minutes, à une température de décapage de 700 °C à 1200 °C dans une chambre à MPCVD ayant une atmosphère dotée d'une pression de 13,3 à 40 kPa (100 à 300 torr), et dans lequel l'atmosphère de ladite chambre comprend de 0,1 % à 10 % d'oxygène par unité d'hydrogène ;
(c) la croissance d'une couche de surface de diamant d'une densité de défauts cristallins extrêmement faible sur le germe ou substrat de diamant nettoyé ou décapé, moyennant quoi cette étape est effectuée une ou plusieurs fois comme processus de pré-croissance pour la production d'un diamant monocristallin de qualité électronique par dépôt chimique en phase vapeur par plasma micro-onde (MPCVD) sur la surface de croissance du germe de diamant, dans lequel le processus de pré-croissance se déroule à une température de 700 °C à 1200 °C dans une chambre à MPCVD, dans lequel l'atmosphère comprend de 1 % à 15 % de $CH_4$ par unité de $H_2$ seulement, éventuellement avec un mélange supplémentaire de 1 % à 50 % de $O_2$ par unité de $CH_4$ ; et
(d) la croissance d'un diamant monocristallin de qualité électronique par-dessus la couche de surface de diamant de faible densité de défauts cristallins, dans lequel la vitesse de croissance du diamant monocristallin de qualité électronique va de 1 $\mu$m/heure à 15 $\mu$m/heure.

2. Procédé selon la revendication 1, dans lequel le germe ou le substrat de diamant ont une orientation de {100}.

3. Procédé selon les revendications 1 ou 2, dans lequel l'étape (a) consiste à examiner les images optiques à fort grossissement de 100X pour rechercher des défauts de surface, des défauts induits par le polissage, des dislocations et des inclusions.

4. Procédé selon l'une quelconque des revendications précédentes, dans lequel l'étape (a) consiste en outre à réaliser ensuite une imagerie à polarisation croisée sur le germe de diamant pour rechercher la présence d'une éventuelle imperfection de la structure cristalline résultant d'une contrainte, et à effectuer une vérification de l'axe cristallin du substrat pour s'assurer que l'angle hors axe par rapport à l'axe d'orientation {100} ne dépasse pas 3 degrés, et si nécessaire, à attaquer la surface supérieure pour révéler et/ou éliminer le dommage superficiel afin de réduire la densité de défauts globale.

5. Procédé selon la revendication 1, dans lequel le procédé de décapage au plasma pour les préparations du diamant se déroule dans une chambre à MPCVD parfaitement exempte d'azote, et la chambre à MPCVD comprend des précurseurs gazeux qui sont bien purifiés de sorte que le nombre total d'impuretés est inférieur à 500 ppb.

6. Procédé selon l'une quelconque des revendications précédentes, dans lequel l'étape (d) consiste en outre à réguler la température d'une surface de croissance d'environ 700 °C à environ 1200 °C dans une chambre à MPCVD, dans lequel la pression va de 13,3 à 40 kPa (100 à 300 torr) et l'atmosphère comprend un mélange de 0,1 % à 15 % de $CH_4$ par unité de $H_2$.

7. Procédé selon l'une quelconque des revendications précédentes, dans lequel on contrôle bien l'incorporation des impuretés en s'assurant que la chambre à MPCVD où se déroule la croissance du diamant est parfaitement exempte d'azote, et en s'assurant également que les précurseurs gazeux sont bien purifiés de sorte que le nombre total d'impuretés est inférieur à 500 ppb.

8. Diamant monocristallin de qualité électronique comprenant :

un rendement de collection de charge (CCE) de 100 % lorsque le champ de polarisation est d'au moins 0,2 V/$\mu$m,
un faible taux d'azote défini par une absence de signal pour les centres mono-azote de substitution $[N-C]^0$, indiquant une concentration desdits centres mono-azote de substitution inférieure à 100 ppb sous FTIR et inférieure à 100 ppb sous spectroscopie d'absorption UV-VIS à 270 nm, et généralement inférieure à 30 ppb sous résonance paramagnétique électronique (EPR), une absence d'absorption d'étirement C-H et de vibrations liées à l'hydrogène dans la gamme spectrale infrarouge (IR) de 2500 cm⁻¹ à 3400 cm⁻¹ lorsque la transmittance infrarouge est supérieure à 70 % dans un spectre FTIR, et
une concentration de lacunes liées au silicium inférieure à 50 ppb définie par une absence de traces de pics de lacunes liées au silicium (SiV) à 738 nm, de pics de lacunes liées à l'azote (NV-) à 637 nm sous spectroscopie de photoluminescence.

9. Diamant monocristallin de qualité électronique selon la revendication 8, dans lequel l'azote de substitution a des valeurs de $[NVH]^0$ = 3123 cm$^{-1}$, de $Ns^+$ = 1332 cm$^{-1}$ et de $Ns^0$ = 1344 cm$^{-1}$ et les vibrations liées à l'hydrogène ont une valeur de 2500 cm$^{-1}$ à 3400 cm$^{-1}$.

10. Diamant monocristallin de qualité électronique selon la revendication 8 ou 9, dans lequel le diamant a une résistance supérieure à $1\times10^{15}$ $\Omega$ obtenue par mesure I-V, et le diamant a une mobilité électronique en champ de faible intensité $\mu_{0,e}$ supérieure à 1800 cm$^2$/Vs et une mobilité des trous en champ de faible intensité $\mu_{0,h}$ supérieure à 2600 cm$^2$/Vs pour des électrons et des trous à température ambiante.

11. Diamant monocristallin de qualité électronique selon l'une quelconque des revendications 8 à 10, dans lequel la vitesse de saturation ($v_{sat}$) des électrons et des trous est > $1,0\times10^7$ cm/s et $v_{sat,h}$ > $1,4\times10^7$ cm/s respectivement, et la durée de vie du support ($\tau$) pour les électrons, $\tau_e$ > 20,0 ns alors que pour les trous, la durée de vie du support $\tau_h$ > 25,0 ns.

12. Diamant monocristallin de qualité électronique selon l'une quelconque des revendications 8 à 11, présentant en outre une distribution du signal de charge ayant la forme d'une courbe de distribution de Landau où le pic le plus probable de la distribution du signal de charge dépend de la densité des défauts et de impuretés du diamant monocristallin de qualité électronique, et le rapport de la largeur totale à mi-hauteur (FWHM) au pic le plus probable (MP) de la distribution de charge (de Landau) (FHWM/MP) est inférieur à 0,3.

13. Diamant monocristallin de qualité électronique selon l'une quelconque des revendications 8 à 12, présentant en outre un faible défaut de structure cristalline défini par la faible résolution d'énergie des détecteurs à base de diamant, qui correspond à une faible distribution de largeur de la courbe de basculement (RC) qui entraîne un CCE élevé.

14. Diamant monocristallin de qualité électronique selon la revendication 13, dans lequel la distribution de largeur de la courbe de basculement (RC) est inférieure à 4,0 $\mu$Radian, qui sert à obtenir une résolution d'énergie de moins de 0,7 %, dans lequel le faible pourcentage de résolution d'énergie correspond à la faible valeur du rapport de la largeur totale à mi-hauteur (FWHM) au pic le plus probable (MP) de la distribution du signal de charge (négative de Landau), FHWM/MP, dans lequel FHWM/MP < 3,0 % lorsque le détecteur de diamant monocristallin de qualité électronique est exposé à une source de rayonnement sous forme de source de rayonnement d'Américium ($^{241}$Am).

15. Diamant monocristallin de qualité électronique selon l'une quelconque des revendications 8 à 14, comprenant en outre une faible intensité de fluorescence (impuretés) définie par une photoluminescence à basse température (77 K) sous excitations laser à 488 nm qui ne montre aucun défaut visible dans la plage de 490 nm à 900 nm, moyennant quoi le spectre de photoluminescence est obtenu à partir d'une source d'excitation d'Argon de 514,5 nm à température ambiante (295 K) .

16. Diamant monocristallin de qualité électronique selon l'une quelconque des revendications 8 à 15, dans lequel la couche de germe de diamant d'une épaisseur maximale de 2500 $\mu$m est fixée à un substrat, et le diamant a une largeur moyenne de la courbe de basculement très faible, qui ne dépasse pas 40 microradians dans au moins 90 % du volume du diamant, la courbe de basculement étant mesurée pour au moins l'un des plans cristallographiques (220), (331) et (400).

17. Diamant monocristallin de qualité électronique selon l'une quelconque des revendications 8 à 16, présentant en outre une densité aérienne d'inclusions inférieure à 10$^3$/m$^2$.

Figure 1

Figure 2

Figure 3

Figure 4

Figure 5

Figure 6

EP 3 045 570 B1

Figure 7

Figure 8

Figure 9

Figure 10

Figure 11

Figure 12

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- EP 1983080 A2
- US 7887628 B
- US 20130202518 A
- WO 2010010352 A

**Non-patent literature cited in the description**

- **GALBIATI et al.** Performance of monocrystalline diamond radiation detectors fabricated using TiW, Cr/Au and a novel ohmic DLC/Pt/Au electrical contact. *NUCLEAR SCIENCE SYMPOSIUM CONFERENCE RECORD, 2008. NSS '08. IEEE,* 19 October 2008, ISBN 978-1-4244-2714-7, 190-196